# EUROPEAN PATENT APPLICATION

(11) **EP 2 685 799 A2**
(43) Date of publication of application: **15.01.2014**
(21) Application number: 13166784.2
(22) Date of filing: 07.05.2013
(51) Int. Cl.: H05K 7/20

(54) **Electronic device and airflow adjustment member**

(30) Priority: 12.07.2012 JP 2012156617
(71) Applicant: FUJITSU LIMITED, Kawasaki-shi, Kanagawa 211-8588 (JP)
(72) Inventor: Tsujimura, Jiro, Kanagawa, 211-8588 (JP); Sato, Yoichi, Kanagawa, 211-8588 (JP)
(74) Representative: HOFFMANN EITLE

(57) **Abstract**

An electronic device has a board, a heat producing component mounted on the board, a connector mounted on the board and allowing a module component to be fitted thereto, a chassis housing the board, and an air blower configured to cause air to flow through the chassis. Additionally, an airflow adjustment member including a guide portion is placed upstream, in a flow direction of the air, of the heat producing component and the connector, the guide portion being configured to guide part of air flowing toward a region where the connector is placed to a region where the heat producing component is placed.

## Description

### FIELD

The embodiments discussed herein are related to an electronic device and an airflow adjustment member.

### BACKGROUND

In an electronic device such as a server, components such as a memory and a DDC (DC-DC converter) are modularized, and those modularized components are fitted to connectors on a motherboard according to an adopted device configuration. Modularized components are called module components hereinbelow.

In a server, components such as a central processing unit (CPU) and a memory produce heat while the server is operated. When the temperature of a component such as the CPU or the memory exceeds an allowable upper limit temperature set for that component, malfunction or failure might occur. For this reason, in a general server, a cooling fan or the like causes cooling air (also called air below) to flow through a chassis of the server to cool the components therein and discharges heat inside the server to the outside of the chassis.
[Patent Document 1] Japanese Laid-open Utility Model Publication No. 07-42181

In the server configured to cool its components in the chassis by use of the cooling fan or the like, the flow of the cooling air (called an airflow below) changes when the configuration of the module components mounted in the chassis changes. This might result in a poor cooling efficiency.

### SUMMARY

In one aspect, the embodiments aim to provide an electronic device and an airflow adjustment member capable of efficiently cooling heat producing components irrespective of the number of module components mounted in the chassis.

According to an aspect of the technique disclosed, provided is an electronic device including: a board; a heat producing component mounted on the board; a connector mounted on the board and including a latch lever configured to allow a module component to be fitted to and removed from the connector; a chassis housing the board; an air blower configured to cause air to flow through the chassis; and an airflow adjustment member placed upstream, in a flow direction of the air, of the heat producing component and the connector, and including a guide portion configured to guide part of air flowing toward a region where the connector is placed to a region where the heat producing component is placed. The latch lever is located at such a position as to restrict at least part of a flow of the air toward the region where the connector is placed.

With the above electronic device according to the one aspect, part of air flowing toward the region where the connector is placed is guided by the airflow adjustment member to the region where the heat producing component is located. Thereby, the heat producing component may be efficiently cooled without use of a dummy component.

### BRIEF DESCRIPTION OF DRAWINGS

Fig. 1 is a perspective view illustrating an example of a motherboard of a server;
Fig. 2 is a top view of the motherboard in Fig. 1;
Fig. 3 is a perspective view of a server according to a first embodiment;
Fig. 4 is a perspective view illustrating a motherboard of the server in Fig. 3;
Fig. 5A is a perspective view of an airflow adjustment member, and Fig. 5B is a perspective view illustrating a back side of the airflow adjustment member in Fig. 5A;
Fig. 6 is a schematic diagram illustrating the positions of guide portions of the airflow adjustment member;
Fig. 7 is a schematic diagram illustrating the flow of air blown by a cooling fan;
Fig. 8 is a schematic diagram illustrating the flow of air passing under the guide portion and entering a memory-mounted region;
Figs. 9A to 9C are diagrams illustrating a memory board connector;
Figs. 10A and 10B are diagrams illustrating a positional relation between the airflow adjustment member and the connector;
Fig. 11 is a diagram illustrating a positional relation between a latch lever and the guide portion;
Fig. 12 is a plan view illustrating the sizes of the portions of the airflow adjustment member;
Fig. 13 is a diagram illustrating temperature measurement positions;
Fig. 14 is a diagram illustrating temperature measurement results;
Fig. 15 is a plan view of a motherboard of a server according to a second embodiment; and
Fig. 16 is a perspective view illustrating a state in which memory boards and DDC boards are fitted onto the motherboard in Fig. 15.

### DESCRIPTION OF EMBODIMENTS

Before embodiments are described, a prelude for facilitating an easy understanding of the embodiments is given below.

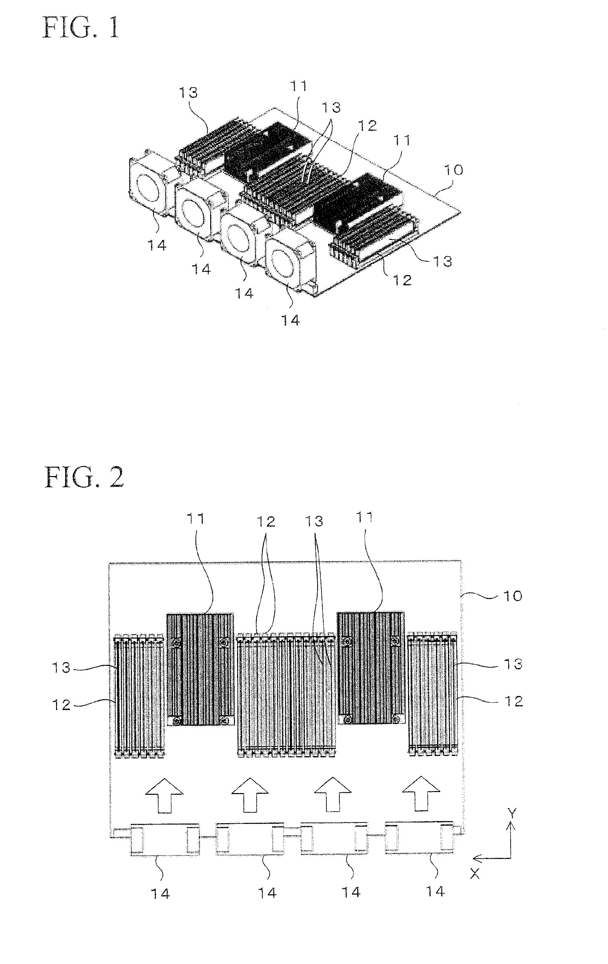

Fig. 1 is a perspective view illustrating an example of a motherboard of a server, and Fig. 2 is a top view of the motherboard in Fig. 1. For convenience of description, two orthogonal directions denoted by X and Y in Fig. 2 are called an X direction and a Y direction, respectively.

CPUs and other components are mounted on a motherboard 10. Since the CPUs produce a large amount of heat upon operation, a heat sink 11 formed of a metal or the like having excellent heat conductivity is attached above each of the CPUs. Heat produced by the CPU moves to the heat sink 11 and is then dissipated to the air through the heat sink 11.

A plurality of memory board connectors (memory slots) 13 are arranged on the motherboard 10. Memory boards 12 are fitted to these connectors 13 according to an adopted device configuration. The memory boards 12 are an example of a module component.

In the example illustrated in Figs. 1 and 2, the plurality of connectors 13 are arranged at positions sandwiching each of the CPUs (the heat sinks 11). The connectors 13 are arranged side by side in the X direction with their longitudinal positions in the Y direction coinciding with each other.

Hereinbelow, a CPU-mounted region refers to a region on the motherboard where the CPU and the heat sink 11 are placed, and a memory-mounted region refers to a region where the memory board is placed.

A plurality of cooling fans 14 are arranged along one side of the motherboard 10, the one side being in parallel with the X direction. These cooling fans 14 introduce air of a relatively low temperature into a chassis of the server to cool the heat sinks 11 and the memory boards 12. The white arrows in Fig. 2 indicate a flow direction of the air.

As mentioned earlier, in an electronic device such as a server, the number of mounted module components differs according to the device configuration. Hence, the airflow through the chassis changes depending on the number of mounted module components.

For example, if the memory boards 12 are fitted to all of the connectors 13 on the motherboard 10, the airflow is blocked due to ventilation resistance by the memory boards 12. Consequently, the amount of air flowing into the memory-mounted regions decreases, so that a relatively large amount of air flows into the CPU-mounted regions.

In contrast, if a few memory boards 12 are mounted, the ventilation resistance by the memory boards 12 is low. This results in increasing the amount of air flowing into the memory-mounted regions, so that a relatively small amount of air flows into the CPU-mounted regions. For this reason, the temperatures of the CPUs tend to be higher when a small number of memory boards 12 is mounted than when a large number of memory boards 12 is mounted.

In a general server, the rotation speed of the cooling fans 14 is controlled according to the temperatures of the CPUs so that the temperatures of the CPUs will not exceed an allowable upper limit. In this case, however, the rotation speed of the cooling fans 14 is increased when a small number of memory boards 12 is mounted; consequently, power consumption increases.

To avoid this, when a small number of memory boards 12 are mounted, a dummy component having almost the same shape as the memory board 12 may be fitted to an empty connector to prevent the change in the ventilation resistance. However, such a measure prefers fitting and unfitting of the dummy component when the device configuration is changed. This not only complicates work, but also increases cost for manufacturing and storage of the dummy component.

In embodiment below, a description is given of an electronic device and an airflow adjustment member which may make a ventilation resistance substantially constant irrespective of the number of mounted module components and may efficiently cool heat-producing components without using dummy components.

### (First Embodiment)

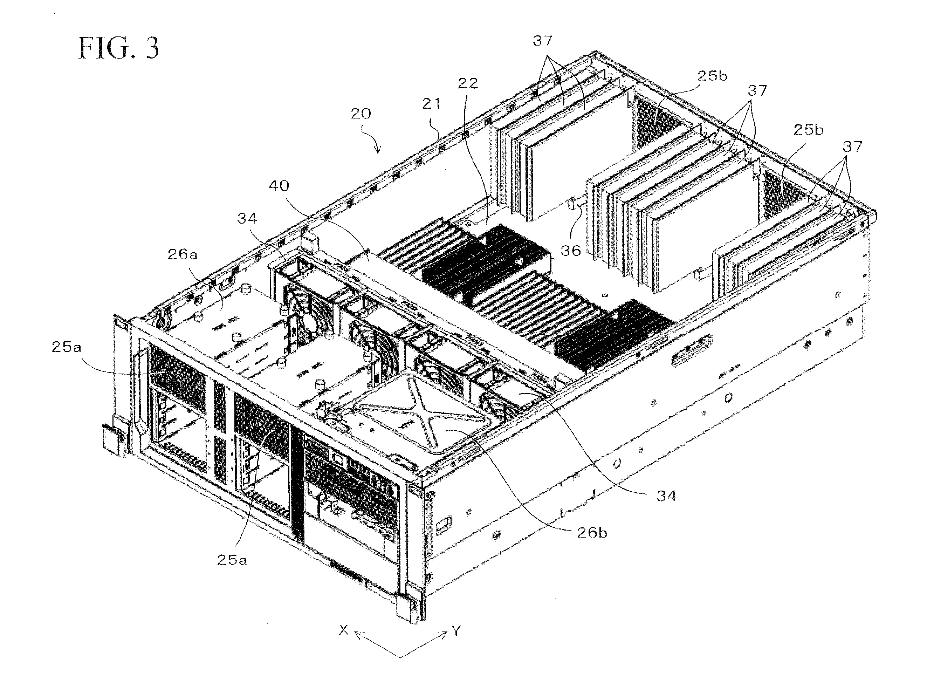

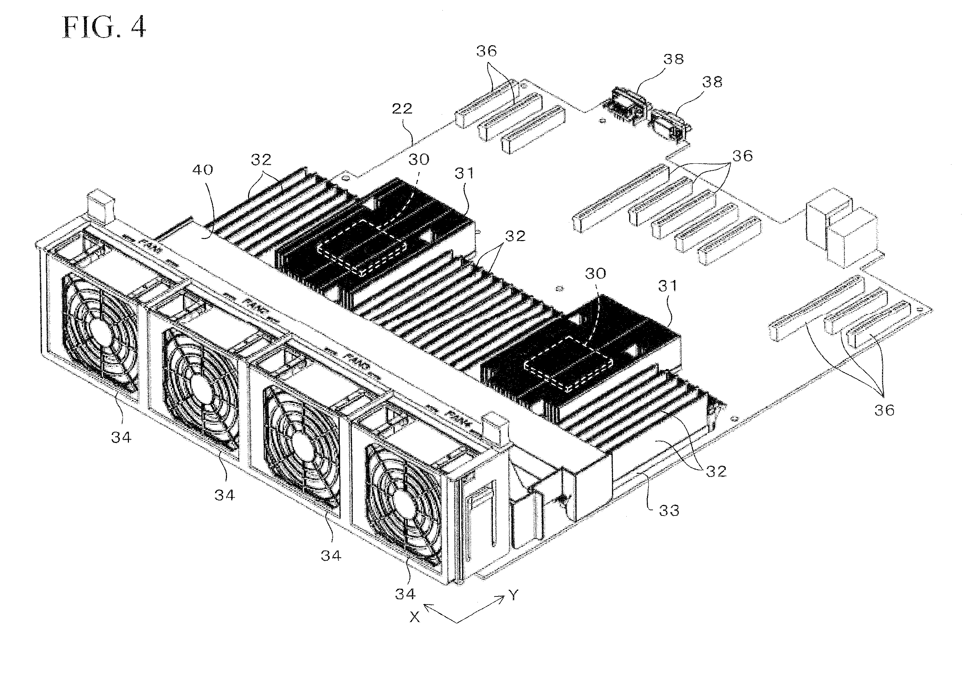

Fig. 3 is a perspective view of a server according to a first embodiment, and Fig. 4 is a perspective view illustrating a motherboard of the server in Fig. 3.

For convenience of description, two orthogonal directions denoted by X and Y in Figs. 3 and 4 are called an X direction and a Y direction, respectively. In addition, in this embodiment, in the server illustrated in Fig. 3, the upstream side and downstream side of a flow direction of air are called a front side and a rear side, respectively. In this embodiment, the electronic device is a server, and the module component is a memory board.

As illustrated in Fig. 3, a server 20 has a chassis 21 and a motherboard 22 housed inside the chassis 21. The chassis 21 is provided at its front side with a front panel 25a and at its rear side with a rear panel 25b. These panels 25a and 25b are each provided with vents. HDD cages 26a and an operation panel unit 26b are placed between the front panel 25a and the motherboard 22. A hard disk drive is to be placed inside each HDD cage 26a.

CPUs 30 and other electronic components are mounted on the motherboard 22. A heat sink 31 formed of a metal having excellent heat conductivity is attached above each CPU 30. The heat sink 31 is provided with many fins extending in the X direction, and air flowing between those fins discharges heat produced by the CPU 30 to the outside.

Moreover, a plurality of memory board connectors (memory slots) 33 are arranged on the mother board 22. Memory boards 32 are fitted to the memory board connectors 33 according to an adopted device configuration. Each memory board 32 is a board on which one or a plurality of semiconductor memory devices (large-scale integrated memory (LSI)) are mounted.

In the example illustrated in Figs. 3 and 4, the plurality of memory board connectors 33 are arranged on both sides, in the X-direction, of each CPU 30 (heat sink 31). These connectors 33 are arranged side by side in the X direction with their longitudinal positions in the Y direction coinciding with each other. Figs. 3 and 4 illustrate a state where the memory boards 32 are fitted to all the connectors 33.

A plurality of cooling fans 34 (four of them in Figs. 3 and 4) are arranged along one side of the motherboard 22 which is at the front. These cooling fans 34 cause air to flow in the Y direction in Figs. 3 and 4 to cool the CPUs 30 (heat sinks 31) and the memory boards 32. For example, the motherboard 22 has a sensor configured to detect the temperatures of the CPUs 30 and a controller configured to control the rotation speed of the cooling fans 34 according to an output of the sensor. When the temperatures of the CPUs 30 are high, the rotation speed of the cooling fans 34 is increased.

A plurality of expansion card slots 36 are arranged at a rear portion of the motherboard 22. Expansion cards 37 according to the device configuration are fitted to the expansion card slots 36. In addition, communication connectors 38 and the like are provided at a rear portion of the motherboard 22. The server 20 communicates with another electronic device via a communication cable attached to the communication connector 38.

The motherboard 22 is an example of a board, the CPU 30 is an example of a heat producing component, and the cooling fan 34 is an example of an air blower.

In general, the CPU 30 produces more heat than the memory board 32. Thus, in order to accomplish reduction in power consumption by decreasing the rotation speed of the cooling fans 34, it is important to efficiently cool the CPU 30. Hence, in this embodiment, an airflow adjustment member 40 is placed windward of the CPU-mounted regions and the memory-mounted regions.

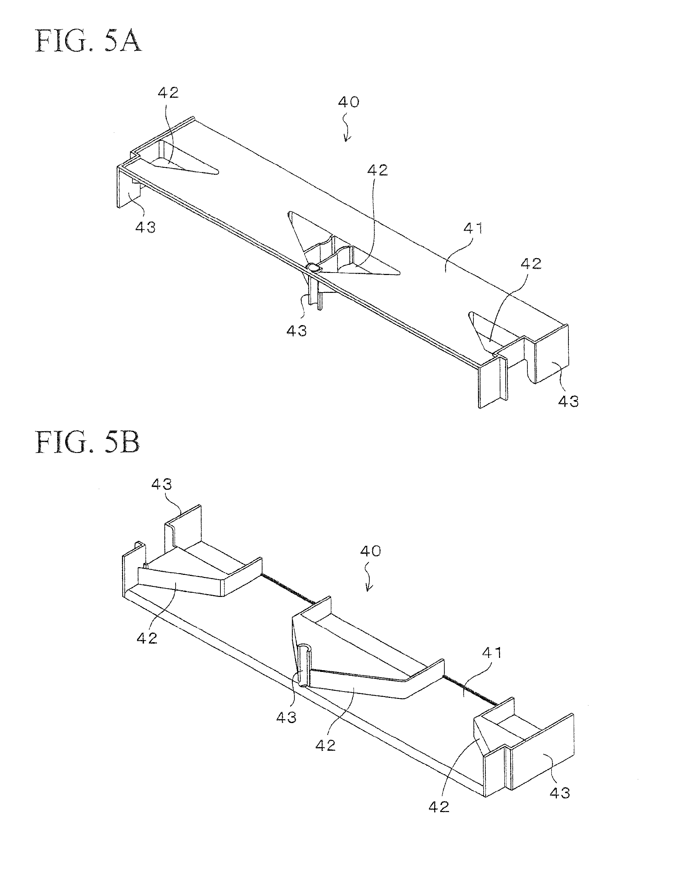

Fig. 5A is a perspective view of the airflow adjustment member 40, and Fig. 5B is a perspective view of a back side of the airflow adjustment member 40 in Fig. 5A.

As illustrated in Figs. 5A and 5B, the airflow adjustment member 40 has a support portion 41, guide portions 42, and attachment portions 43. The support portion 41 has a flat plate shape, and the guide portions 42 are triangular and arranged on the lower face of the support portion 41. The attachment portions 43 are provided at both ends and the center portion, in the longitudinal direction, of the support portion 41, and are used to fix the airflow adjustment member 40 to a predetermined position on the motherboard 22.

In this embodiment, the airflow adjustment member 40 is formed of polycarbonate. Note, however, that the airflow adjustment member 40 may be formed by a material other than polycarbonate.

The airflow adjustment member 40 is placed such that the triangle vertices of the guide portions 42 face the cooling fans 34. When the airflow adjustment member 40 is placed at the predetermined position on the motherboard 22, a rear end portion of the support portion 41 cover front end portions of the connectors 33 from above.

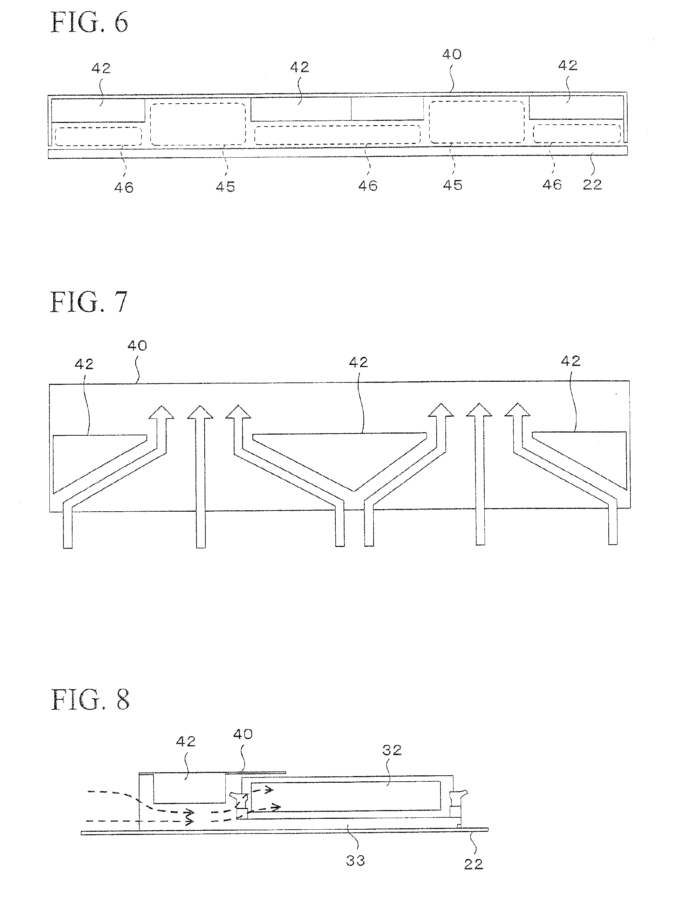

As Fig. 6 schematically illustrates, when seen from the windward, the guide portions 42 are located at positions corresponding to the memory-mounted regions 46, and are not provided at positions corresponding to the CPU-mounted regions 45. Thus, as illustrated in Fig. 7, part of air blown by the cooling fans 34 and flowing toward the memory-mounted regions 46 travels along inclined surfaces of the guide portions 42, merges with air blown by the cooling fans 34 and flowing toward the CPU-mounted regions 45, and then travels to the CPU-mounted regions 45.

As illustrated in Fig. 6, there is a space between the guide portions 42 and the motherboard 22. Thus, as illustrated in Fig. 8, rest of the air blown by the cooling fans 34 and flowing toward the memory-mounted regions 46 travels under the guide portions 42 and enters the memory-mounted regions 46 to cool the memory boards 32.

In this embodiment, since the airflow adjustment member 40 is placed windward of the CPU-mounted regions 45 and the memory-mounted regions 46 as described above, the CPU-mounted regions 45 are supplied with the air preferentially over the memory-mounted regions 46. Hence, the CPUs 30 may be sufficiently cooled even when the rotation speed of the cooling fans 34 is low, and therefore power consumed by the cooling fans 34 may be reduced.

Incidentally, as seen from Fig. 8, the front end portions of the memory board connectors 33 are obstacles for the air having flowed under the guide portions 42. Thus, in this embodiment, the states of the front end portions of the memory board connectors 33 largely influence the flow rate of the air supplied to the memory-mounted regions 46. On the other hand, since the ventilation resistance by the memory boards 32 is smaller than that by the connectors 33, the flow rate of air does not change much no matter whether the memory board 32 is fitted to the connectors 33 or not.

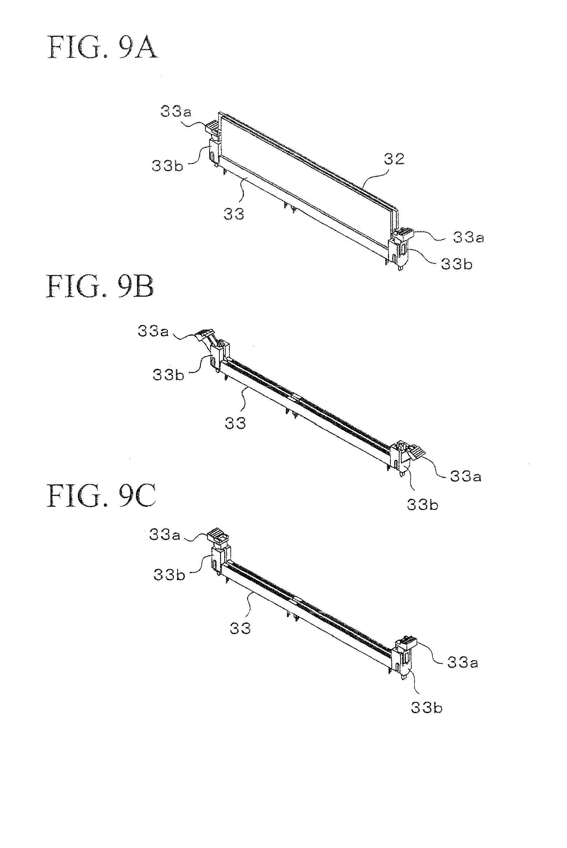

Figs. 9A to 9C are diagrams illustrating the memory board connector 33. Fig. 9A illustrates a state where the memory board 32 is fitted to the connector 33, and Figs. 9B and 9C each illustrate a state where the memory board 32 is not fitted to the connector 33.

Both longitudinal ends of the connector 33 each have a column portion 33b configured to support an end portion of the memory board 32 and a latch lever 33a configured to open and close by rotating about a fulcrum provided to the column portion 33b. When the memory board 32 is being fitted to the connector 33, the latch levers 33a are closed to fix the memory board 32 to the connector 33 as illustrated in Fig. 9A in order to prevent the memory board 32 from coming off by vibration or the like, or to prevent a contact failure and the like.

When the memory board 32 is not fitted to the connector 33, the latch levers 33a are generally kept open as illustrated in Fig. 9B. However, in this embodiment, whether the latch levers 33a are kept open or closed largely changes the flow rate of air flowing into the memory-mounted regions 46, and also changes the flow rate of air flowing into the CPU-mounted regions 45.

In this embodiment, even while the memory board 32 is not fitted to the connector 33, the latch levers 33a are kept closed as illustrated in Fig. 9C. This allows the ventilation resistance by the connector 33 to be always constant.

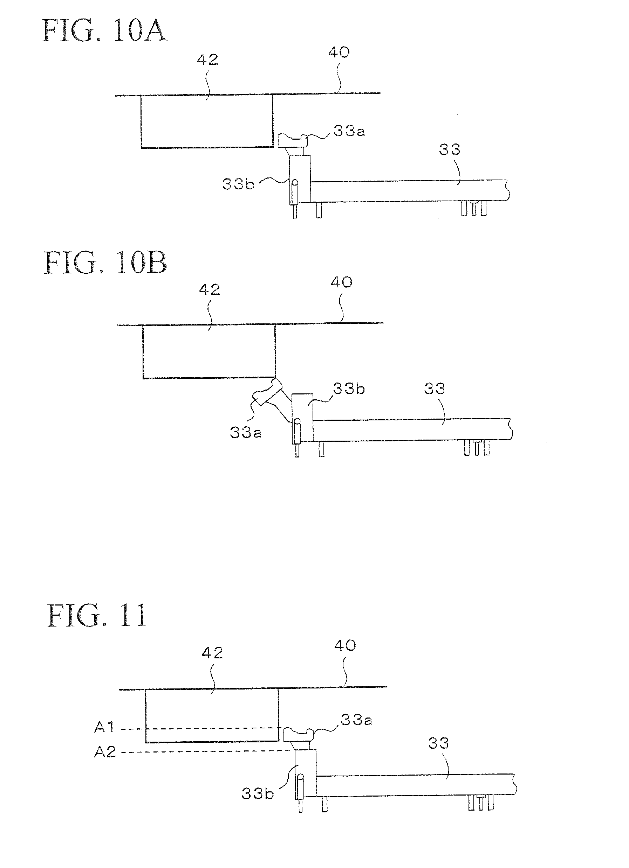

Figs. 10A and 10B are diagrams illustrating a positional relation between the airflow adjustment member 40 and the connector 33. As illustrated in Fig. 10A, in this embodiment, the airflow adjustment member 40 may be attached to the predetermined position when the latch levers 33a are closed. On the other hand, when the latch levers 33a are open, the airflow adjustment member 40 comes into contact with the latch levers 33a as illustrated in Fig. 10B, and the airflow adjustment member 40 is therefore not attached to the predetermined position. This allows prevention of forgetting to close the latch levers 33a.

In order to attain the effect of preventing forgetting to close the latch levers 33a, it is important that, as illustrated in Fig. 11, the position of a lower end of the guide portion 42 be located lower than position A1 of an upper end of the closed latch lever 33a when the airflow adjustment member 40 is attached to the predetermined position.

If the position of the lower end of the guide portion 42 is located lower than position A2 of an upper end of the column portion 33b of the connector 33, the space between the guide portion 42 and the motherboard 22 is narrowed to decrease the flow rate of air supplied to the memory-mounted regions 46. For this reason, the position of the lower end of the guide portion 42 is preferably higher than position A2 of the upper end of the column 33b of the connector 33 when the airflow adjustment member 40 is attached to the predetermined position.

Further, in this embodiment, the guide portions 42 function as a latch lever open-close state detector configured to detect whether the latch levers 33a are open or closed. Alternatively, the airflow adjustment member 40 may be provided with a latch lever open-close state detector, separate from the guide portions 42.

As described above, in this embodiment, the airflow adjustment member 40 is not placed at the predetermined position when the latch levers 33a are open. Hence, the ventilation resistance against the air flowing under the guide portions 42 is almost constant, irrespective of whether the memory board 32 is fitted to the connector 33 or not. As a result, a ratio of air flowing into the CPU-mounted regions 45 to air flowing into the memory-mounted regions 46 is almost constant.

Moreover, in this embodiment, as illustrated in Fig. 8, the rear end portion of the airflow adjustment member 40 covers the end portion of the memory board 32 from above. Thereby, after flowing under the guide portions 42, air travels in the longitudinal direction of the memory board 32 without spreading upward. This allows the memory boards 32 to be efficiently cooled as well.

A description is given below of results of examining a change in the temperatures of the CPUs when the memory boards are mounted and when the memory board are not mounted.

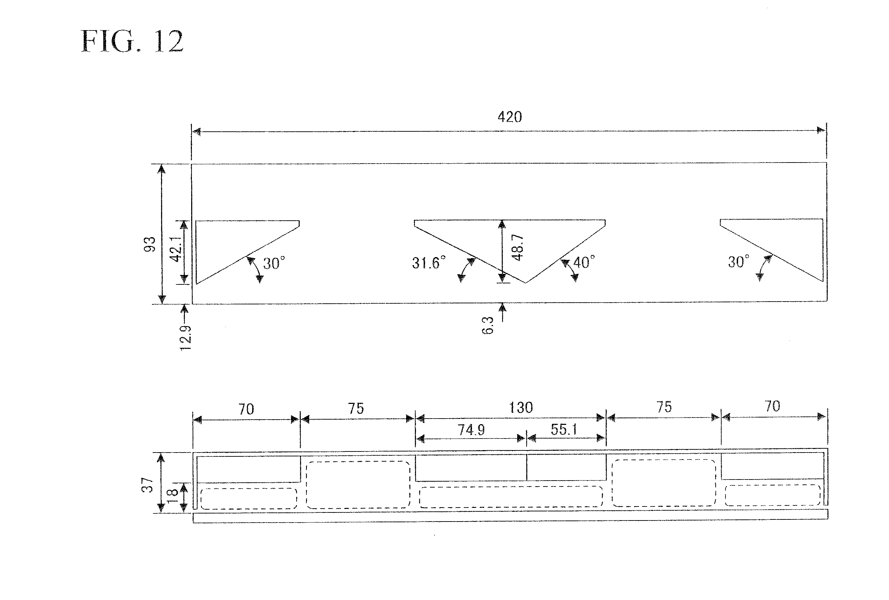

As an embodiment example, a server having a structure illustrated in Fig. 3 is prepared. The sizes of the portions of the airflow adjustment member 40 are as depicted in Fig. 12.

A server of a comparative example is also prepared. The server of the comparative example has the same airflow adjustment member 40 as that of the embodiment example except that it does not have the guide portions 42.

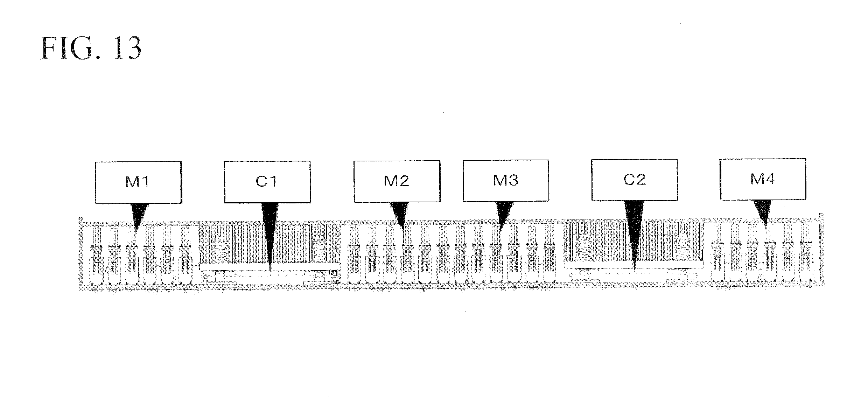

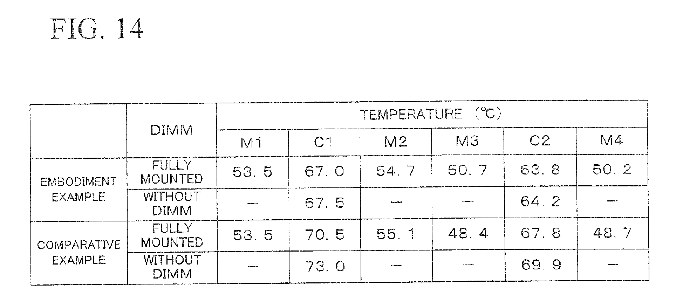

For each of the embodiment example and the comparative example, the temperatures of the CPUs and the temperatures of the memory boards in a case where the memory boards (DIMM) are fitted to all the connectors are measured, and the temperatures of the CPUs in a case where the memory boards are removed from all the connectors are measured. Fig. 13 depicts positions of the temperature measurements, and Fig. 14 depicts results of the temperature measurements.

In Fig. 13, C1 and C2 are the positions where the temperatures of the CPUs are measured, and M1 to M4 are the positions where the temperatures of the memory boards are measured. Further, in Fig. 14, temperatures under "fully mounted" are temperatures measured when the memory boards (DIMM) are fitted to all the connectors, and temperatures under "without DIMM" are temperatures measured when the memory boards are removed from all the connectors.

As seen from Fig. 14, in the embodiment example, the difference in the temperatures of the CPUs between when the memory boards are mounted and when the memory boards are not mounted is as small as 0.4°C to 0.5°C. In contrast, in the comparative example, the difference in the temperatures of the CPUs between when the memory boards are mounted and when the memory boards are not mounted is as large as 2.1°C to 2.5°C.

Further, the temperatures of the CPUs of the embodiment example when the memory boards are mounted are lower than those of the comparative example by 3.5°C to 4.0°C, and the temperatures of the CPUs of the embodiment example when the memory boards are not mounted are lower than those of the comparative example by 5.5°C to 5.7°C. Note that the temperatures of the memory boards are almost the same in the embodiment example and the comparative example.

As seen from the above results of the temperature measurements, irrespective of whether the memory boards are mounted or not, the CPUs are cooled more efficiently in the server of the embodiment example than in the server of the comparative example.

### (Second Embodiment)

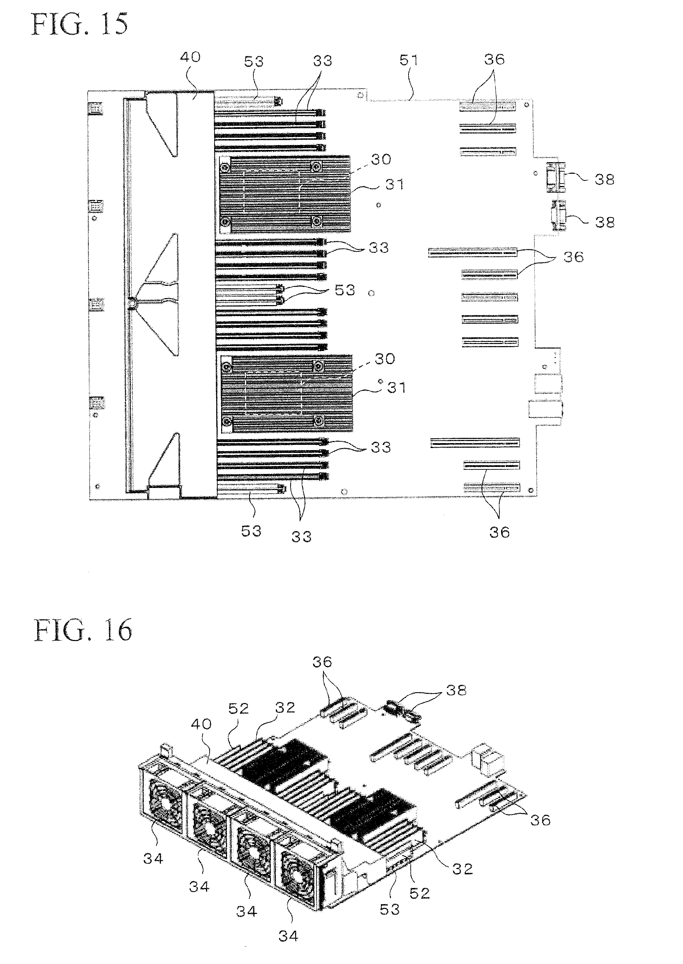

Fig. 15 is a plan view of a motherboard of a server according to a second embodiment, and Fig. 16 is a perspective view of the motherboard in Fig. 15, to which memory boards and DDC (DC-DC converter) boards are fitted. This embodiment differs from the first embodiment in that the motherboard is provided with connectors to which the DDC boards are to be fitted, and other configurations of this embodiment are basically the same as those of the first embodiment, and are therefore not described again here.

As illustrated in Fig. 15, a motherboard 51 is provided with the memory board connectors 33 to which the memory boards 32 are to be fitted and DDC board connectors 53 to which DDC boards 52 are to be fitted. The memory board connectors 53 are located at DDC-mounted regions adjacent to the memory-mounted regions where the memory board connectors 33 are placed. The DDC board 52 is a board on which one or a plurality of DDCs are mounted. Like the memory board connector 33, the DDC board connector 53 is provided at its both end portions with latch levers for fixing the DDC board 52.

Similar to the first embodiment, the airflow adjustment member 40 is placed windward of the memory board connectors 33 and the DDC board connectors 53. The airflow adjustment member 40 is provided with the guide portions 42 (see Figs. 5A and 5B).

Part of air blown by the cooling fans 34 and flowing toward the memory-mounted regions and the DDC-mounted regions travels along the inclined surfaces of the guide portions 42, merges with air blown by the cooling fans 34 and flowing toward the CPU-mounted regions, and then travels toward the CPU-mounted regions.

Rest of the air blown by the cooling fans 34 and flowing toward the memory-mounted regions and the DDC-mounted regions flows under the guide portions 42 and enters the memory-mounted regions and the DDC-mounted regions to cool the memory boards 32 and the DDC boards 52.

As described above, the technique disclosed may be used even when module components other than the memory boards 32 are used as the module components.

## Claims

1. An electronic device comprising:
a board (22);
a heat producing component (30) mounted on the board (22);
a connector (33) mounted on the board (22) and including a latch lever (33a) configured to allow a module component (32) to be fitted to and removed from the connector (33);
a chassis (21) housing the board (22);
an air blower (34) configured to cause air to flow through the chassis (21); and
an airflow adjustment member (40) placed upstream, in a flow direction of the air, of the heat producing component (30) and the connector (33), and including a guide portion (42) configured to guide part of air flowing toward a region where the connector (33) is placed to a region where the heat producing component (30) is placed, wherein
the latch lever (33a) is located at such a position as to restrict at least part of a flow of the air toward the region where the connector (33) is placed.

2. The electronic device according to claim 1, wherein
the latch lever (33a) opens and closes by rotating about a fulcrum provided to a column portion (33b) of the connector (33) located at an end portion of the connector (33) on the airflow adjustment member side, the latch lever (33a) being configured to allow the module component (32) to be fitted to and removed from the connector (33) when opened, and
the airflow adjustment member (40) includes a latch lever open-close detector (42) configured to come into contact with the latch lever (33a) when the latch lever (33a) is open, and thereby prevent the airflow adjustment member (40) from being placed at a predetermined position.

3. The electronic device according to claim 2, wherein
when the airflow adjustment member (40) is at the predetermined position, the latch lever open-close detector (42) is located at a position higher than the column portion (33b) of the connector (33).

4. The electronic device according to any one of claims 1 to 3, wherein
the heat producing component (30) and the connector (33) are arranged side by side in a direction intersecting the flow direction of the air sent from the air blower (34).

5. The electronic device according to any one of claims 1 to 3, wherein
a plurality of the connectors (33) are arranged side by side.

6. The electronic device according to any one of claims 1 to 3, wherein
the heat producing component (30) is a CPU, and
the module component (32) is a memory board on which a semiconductor memory device is mounted.

7. The electronic device according to any one of claims 1 to 3, wherein
the heat producing component (30) is a CPU, and
the module component (52) is a DDC (DC-DC converter) board on which a DDC is mounted.

8. An airflow adjustment member placed inside a chassis (21) of an electronic device (20), the airflow adjustment member comprising:
a support portion (41) having a flat plate shape; and
a guide portion (42) located on one of surfaces of the support portion (41) and configured to guide part of air flowing along the one surface of the support portion (41) in a direction intersecting a flow direction of the air.

9. A method of cooling a heat producing component in an electronic device having a board (22), a heat producing component (30) mounted on the board (22), a connector (33) mounted on the board (22) and including a latch lever (33a) configured to allow a module component (32) to be fitted to and removed from the connector (33), a chassis (21) housing the board (22), an air blower (34) configured to cause air to flow through the chassis (21), and an airflow adjustment member (40) placed upstream, in a flow direction of the air, of the heat producing component (30) and the connector (33), and configured to adjust a flow of the air sent from the air blower (34), the method comprising:
guiding part of air flowing toward a region where the connector (33) is placed to a region where the heat producing component (30) is placed, by the airflow adjustment member (40); and
restricting at least part of a flow of the air toward the region where the connector (33) is placed, by the latch lever (33a).
